Europäisches Patentamt

(19) European Patent Office

Office européen des brevets

(11) Publication number: **0 077 825**
**B1**

(12) **EUROPEAN PATENT SPECIFICATION**

(45) Date of publication of patent specification: **12.08.87**

(51) Int. Cl.⁴: **H 01 L 21/76,** H 01 L 21/208,
H 01 S 3/00, H 01 L 21/20

(21) Application number: **82901772.2**

(22) Date of filing: **04.05.82**

(86) International application number:
**PCT/US82/00574**

(87) International publication number:
**WO 82/03946 11.11.82 Gazette 82/27**

(54) **METHOD OF FORMING WIDE BANDGAP REGION WITHIN MULTILAYER SEMICONDUCTORS.**

(30) Priority: **06.05.81 US 260956**
**22.04.82 US 370756**

(43) Date of publication of application:
**04.05.83 Bulletin 83/18**

(45) Publication of the grant of the patent:
**12.08.87 Bulletin 87/33**

(84) Designated Contracting States:
**DE FR GB NL**

(56) References cited:
**US-A-3 485 685
US-A-3 626 328
US-A-3 868 281
US-A-3 982 207
US-A-4 001 055
US-A-4 045 252
US-A-4 099 999
US-A-4 124 826
US-A-4 138 274
US-A-4 165 474
US-A-4 169 727
US-A-4 183 038**

(73) Proprietor: **UNIVERSITY OF ILLINOIS
FOUNDATION
224 Illini Union 1401 West Green Street
Urbana, IL 61801 (US)**

(72) Inventor: **HOLONYAK, Nick, Jr.
2212 Fletcher
Urbana, IL 61801 (US)**
Inventor: **LAIDIG, Wyn Davis
Rt. 4, Box 464
Raleigh, N.C. 27606 (US)**

(74) Representative: **Skone James, Robert Edmund
et al
GILL JENNINGS & EVERY 53-64 Chancery Lane
London WC2A 1HN (GB)**

(56) References cited:
**US-A-4 199 385
US-A-4 211 586
US-A-4 249 967
US-A-4 261 771**

(58) References cited:
APPLIED PHYSICS LETTERS, vol. 23, no. 8,
October 15, 1973, NEW YORK (US) P.PETROFF
et al.: "Defect structure introduced during
operation of heterojunction GaAs lasers",
pages 469-471

RADIATION EFFECTS, VOL. 5, (1970), 245-249,
WESTMORELAND ET AL.: "LATTICE DISORDER
PRODUCED IN GaAs BY 60 KEV Cd IONS AND
70 KEV Zn IONS"

**Description**

Field of the invention

This invention relates to improvement in semiconductive devices, and more particularly to a method for producing integrated light emitting semiconductor devices. The United States Government has rights in this invention as a result of financial support by NSF grants DMR 79-09991 and DMR 77-23999.

Background of the invention

Light emitting semiconductors are well known in the prior art. One of the more widely used light emitting devices is a heterojunction light emitter fabricated, for example, using a gallium arsenide/aluminum gallium arsenide material system. In such devices, a pair of relatively wide band gap layers (aluminum gallium arsenide) of opposite conductivity type are sandwiched around an active region (gallium arsenide). The interfaces between the active region and the wide band gap layers form a pair of heterojunctions. These heterojunctions effectively provide both carrier and optical confinement. The devices are generally used as light emitting diodes or lasers and may be energized using an electrical current or by optical pumping.

A previously proposed improved light emitting device is described in US—A—4,439,782 (published 27.03.84).

Therein is described a light emitting device wherein the active region comprises one or more layers of gallium arsenide separated by aluminum arsenide barrier layers. The aluminum arsenide binary layers replace previously employed aluminum gallium arsenide ternary barrier layers for the reason that the latter ternary layers have been found to be inherently disordered and to exhibit alloy clustering in the regions adjacent to the gallium arsenide/aluminum gallium arsenide interface. That clustering leads to the device requiring larger threshold currents and exhibiting lower efficiencies. The disclosure and teachings of the aforementioned patent application are incorporated herein by reference.

Light emitting devices such as those described above are generally, although not necessarily, grown by metalorganic chemical vapor deposition ("MO-CVD"), which is described, for example, in a publication entitled "Chemical Vapor Deposition for New Material Applications", appearing in the June, 1978, issue of "Electronic Packaging and Production". Such devices are also grown by molecular beam epitaxy, liquid phase epitaxy, or other suitable deposition techniques. The MO-CVD and MBE processes are generally the preferred ones.

In all of the aforementioned processes, the light emitting devices are produced in wafer form, which wafer is then cleaved or cut to produce individual light-emitting diodes or lasers. This is in contrast to the well-known integrated circuit technology wherein large numbers of active devices are constructed and interconnected on a single chip. Such integration, heretofore, has been unavailable, on a practical basis, for the above-mentioned light emitting semiconductor devices. Attempts to integrate light emitting devices have generally been rather crude-involving the actual physical emplacement of light-emitting structures in etched-out substrates. Such a structure is shown in US—A—4,165,474.

It is clear that an economic method of integrating heterojunction light emitting devices into larger scale integrated circuits would be an important contribution to the expansion of optical data processing and data communications.

In accordance with the present invention, a method of forming a disordered semiconductor alloy comprises introducing a disordering element into a semiconductor structure including a first active semiconductor region disposed on a second semiconductor barrier layer and which together have a crystalline structure, whereby the disordering element compositionally disorders the first active region and the second barrier layer while the crystalline structure is maintained, and the alloy formed of the first and second semiconductors exhibits a higher energy gap than the first active semiconductor region.

The invention enables superlattice layers to be disordered and shifted up in energy gap, while remaining single crystal, by introduction of a disordering element, such as by diffusion or implantation. This enables the production of integrated electro-optical and semiconductor devices through a disordering/isolation process which method is both simple and fits with present semiconductor processing technology.

The invention also enables the integration of for example III—V compound heterojunction devices into an overall integrated structure to be disordered and shifted up in energy gap, while maintaining the crystalline structure, by introduction of a disordering element, such as by diffusion or implantation. For example, all or selected portions of a multilayer of either gallium arsenide/aluminium arsenide or gallium arsenide/aluminium gallium arsenide can be converted into single crystal aluminium gallium arsenide having a higher energy gap than that of the original structure by the process of a zinc diffusion or by implantation of silicon or krypton or zinc ions. Other active devices can then be constructed in the higher energy gap material using established semiconductor processing steps.

Some examples of methods according to the invention will now be described with reference to the accompanying drawings, in which:—

Figure 1 is a section view of a superlattice heterostructure constructed in accordance with the teachings of US—A—4439782;

Figure 2 is the structure of Figure 1 after selective disordering and additional processing;

Figure 3 is the device of Figure 2 after the electrical contacts have been emplaced;

Figure 4 is a plan view of the light emitting device of Figure 3;

Figure 5 is a field effect transistor constructed by one method in accordance with invention; and,

Figure 6 is a plan view of an integrated optical processing device.

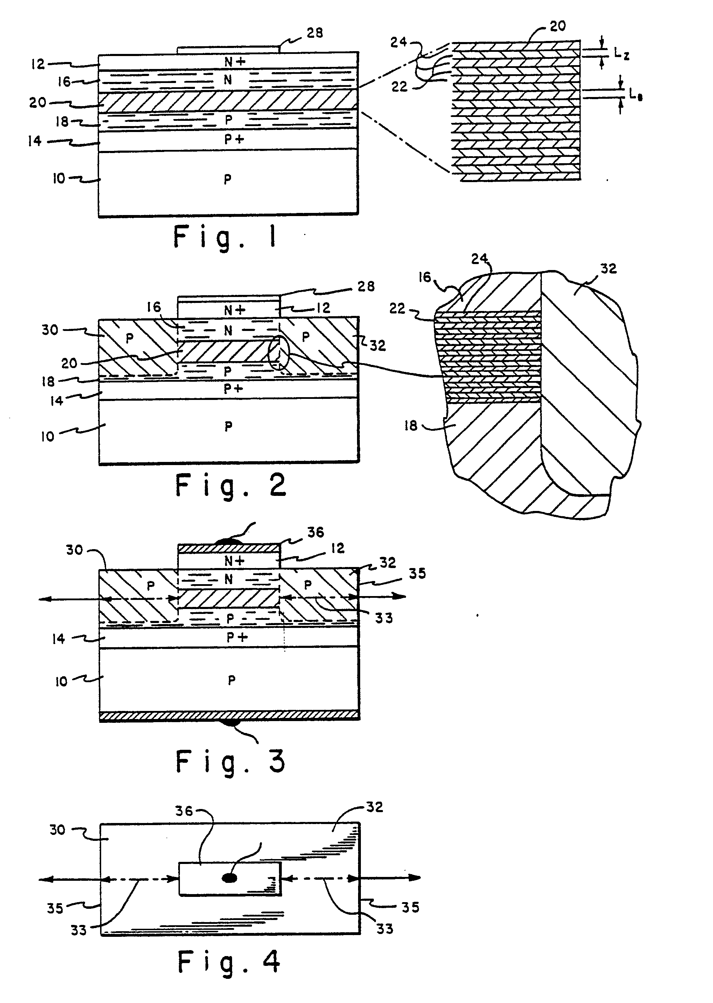

Referring now to Figure 1, there is shown a semiconductor heterostructure device in accordance with that described in US—A—4439782. The entire device is constructed on a gallium arsenide semi-insulating or conducting substrate 10. A pair of outer buffer or contact layers 12 and 14 encompass a pair of injecting/collecting (i.e. injecting or collecting) regions 16 and 18, which are preferably, although not necessarily, of opposite conductivity type. A superlattice (many-layer) structure 20 is encompassed between regions 16 and 18 which structure is shown in a blown-up view to the right of the device. Superlattice 20 comprises a plurality of interleaved lower gap, active regions 22 sandwiched between higher gap barrier layers 24.

The injecting/collecting confining regions 16 and 18 are of a relatively wide band gap semiconductor material and active layers 22 are of a relatively narrow band gap binary semiconductor material. Barrier layers 24 are of a binary semiconductor material that is lattice-matched to the active layer material 22. While not the most preferred embodiment, barrier layers 24 can also be a ternary semiconductor material which is lattice-matched to the binary active material 22.

In superlattice 20, each active layer 22 is a quantum-well having a thickness in the range of about 2—50 nm (about 20 to 500 Angstroms), with the preferred thickness range being 2—20 nm (20 to 200 Angstroms). Each barrier region 24 should have a thickness of at least about 1 nm (about 10 Angstroms) and preferably be in the range of between about 1—20 nm (about 10 and 200 Angstroms). The number of active layers 22 is essentially subject to choice, but generally is in the range of 4 to 100 layers with the number of barrier regions 24 being one more in number.

An embodiment of the structure of Fig. 1 is as follows:

*layer 12:* 1 µm GaAs: Se (n~$1 \times 10^{18}$ cm$^{-3}$)
*layer 16:* 0.5—2.0 µm Al$_{0.4}$Ga$_{0.6}$As: Se (n~$5 \times 10^{17}$ cm$^{-3}$)
*layers 24:* (thickness=L$_B$) AlAs (doped or undoped)
*layers 22:* (thickness=L$_z$) GaAs (doped or undoped)
*layer 18:* 0.5—2.0 µm Al$_{0.4}$Ga$_{0.6}$As: Zn (p~$2 \times 10^{17}$ cm$^{-3}$)
*layer 14:* 1 µm GaAs: Zn (p~$2 \times 10^{18}$ cm$^{-3}$)

In a form of the invention, it has been found that the diffusion of zinc atoms into superlattice 20 can cause the superlattice to become compositionally disordered Al$_x$Ga$_{1-x}$As, with its energy gap (in one specific case) changed from about E$_g$=1.61 eV (for the gallium arsenide active layer 22) to about E$_g$=2.08 eV. (From dull red to yellow).

In order to accomplish the zinc diffusion only in desired areas, a silicon nitride mask 28 is laid down on the surface of layer 12 using well-known photolithographic processes. The exposed portions of contact region 12 are etched away, exposing the upper surface of confining layer 16. The semiconductor structure along with ZnAs$_2$ is then placed in a quartz ampoule and the combination is placed in a diffusion oven. Zinc is introduced by diffusion in the crystal in the temperature range of 500—600°C, a temperature well below the normal cross diffusion temperature of the superlattice components (i.e., >750°C). The diffusion time is, of course, dependent upon the device structure, but it has been found that diffusion times ranging from 10 to 60 minutes are appropriate.

The zinc atoms diffuse into the exposed regions and cause active regions 22 and barrier regions 24 in superlattice 20 to become compositionally disordered alloy Al$_x$Ga$_{1-x}$As. In other words, the various thin superlattice layers are combined in such a manner as to lose their individual identities, while maintaining the crystalline structure. If barrier regions 24 are AlAs and active regions 22 are GaAs, x~L$_B$/(L$_B$+L$_z$). If the barrier regions 24 are Al$_y$Ga$_{1-y}$As, then x~yL$_B$/(L$_B$+L$_z$). In this instance, y represents the fraction of barrier layer 24 that can be considered as AlAs.

Ordinarily, aluminum/gallium interdiffusion in the temperature range 500—600°C is negligible. It has been found, however, that when zinc is diffused, even at such a low temperature, into AlAs/GaAs superlattices, the zinc enhances the aluminum/gallium interdiffusion. Thus, at a low temperature, and in any pattern desired, the GaAs/AlAs or GaAs/Al$_x$Ga$_{1-x}$As superlattice can be fully disordered and, depending upon the GaAs layer's thickness L$_z$ and the L$_z$/L$_B$ ratio, can be increased in energy gap or even shifted, from direct gap to indirect gap.

In another form of the invention, it has been found that implantation of silicon or krypton ions can also cause the superlattice to become compositionally disordered, while maintaining the crystalline structure. In one example, the AlAs-GaAs superlattice, grown by metalorganic vapor deposition, had alternating undoped layers of GaAs (8.6 nm (86 Angstroms)) and AlAs (8 nm (80 Angstroms)), with 126 layers altogether for a total thickness of 1 µm. Silicon ions were implanted into the superlattice structures at room temperature at 375 keV at an angle of 7° with respect to the substrate. The ion dose was $10^{14}$ cm$^{-2}$. Some samples were subsequently annealed at 675°C for 4 hours in an arsenic-rich atmosphere. Compositional disordering was found to result, with the energy gap, in an annealed case, for the disordered region being about Eg=1.99 eV, and therefore substantially higher than was exhibited by the ordered superlattice, which was about Eg=1.57 eV. Annealing, preferably in a temperature range of about 500°C to 700°C, and below the temperature at which the superlattice was originally grown, appears to be an important aspect of the process in these examples. For an implanted dose of $10^{14}$ $cm^{-2}$ it appears that, before anneal, compositional disordering has not occurred and considerable crystal damage is present. After anneal at temperatures less than the original growth temperature, the damage in the implanted region is removed and compositional disordering is extensive, though not complete.

In other examples, zinc and krypton ions were implanted under similar conditions, and resulted in observable compositional disordering after annealing, although the results for the same dosages exhibited less disordering than was the case with silicon implantation.

Turning now to Fig. 3, silicon nitride layer 28 has been removed and replaced by metallization layer 36. A similar layer of metallization has been applied to the underside of substrate 10 (substrate 10 being conductive in this instance) enabling a light emitting structure to be completed. A plan view of the structure is shown in Fig. 4.

When a potential is applied via contact 36 to the heterojunction laser (or if there are no contacts, the device is optically pumped), a red light is emitted by the GaAs active layers 22 along the long dimension as shown by arrows 33. Since the $Al_xGa_{1-x}As$ regions 30 and 32 are of a higher energy gap (orange or yellow) than the GaAs regions 22, the red light is able to pass therethrough without hindrance. Wafer edges 35 act as Fabry-Perot reflectors, creating a cavity of nonabsorbing $Al_xGa_{1-x}As$ for the laser. Obviously, the structure of the cavity for the heterojunction laser can be designed as desired for optimum performance characteristics. For instance, a larger cavity will provide longer photon transit times, less cavity end loss, a higher Q and a resultant lower threshold laser.

A plurality of light emitting devices such as those above described have been grown on a single substrate and then subsequently isolated by selective introduction of a disordering element, as described, to create individual devices in a monolithic environment. When a zinc diffusion or implantation is used, it creates a p region which is substantially semiconductive in its own right. By subsequently bombarding the exposed p regions with a suitable source of protons, those regions can be sufficiently damaged while still remaining single crystalline so as to create high resistivity isolating barriers between the active devices. Such bombardment does not effect the red light transmissivity of the bombarded regions.

Superlattices having active regions 22 (i.e., GaAs) as thick as 50 nm (500 Angstroms) $(L_z)$ can be compositionally disordered as taught herein. Preferably, however, the thickness of active region 22 should be approximately 20 nm (200 Angstroms) or less for optimum results.

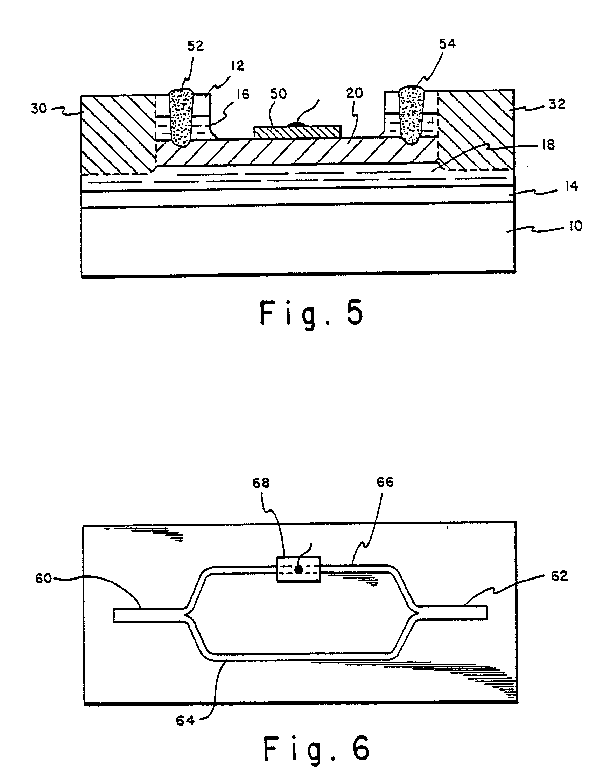

Referring now to Fig. 5, there is shown a sectional view of a Schottky barrier field effect transistor constructed employing the heterostructure configuration of Fig. 1 and isolated from other portions of the circuitry by the disordering process described above. In this instance, regions 12 and 16 have been etched away to open a channel which exposes superlattice layer 20. Metallization contact 50 has been deposited and is used as the gate electrode. N type metallizations 52 and 54 are alloyed into layers 12 and 16 and contact superlattice layer 20. These provide the source and drain contacts for the device. The device of Fig. 5 is illustrated to show the versatility of the selective disordering technique hereof in that a plurality of devices can be integrated into a single monolithic chip and then isolated by the higher gap disordered regions—which are later converted to higher resistivity, if necessary, by proton bombardment. Obviously, additional active devices can be constructed in the disordered regions, if such are desired.

The method of constructing the Schottky barrier device shown in Fig. 5 is conventional in that layer 20 can be high mobility modulation doped, i.e., a donor grown into the barriers but none in the adjacent regions (i.e., GaAs). Layers 12 and 16 are selectively etched away after the upper surface of the device is suitably masked. The last step involves the alloying of junction contact 52 and 54, again after suitable masking.

Referring now to Fig. 6, there is shown a plan view of an integrated structure. In this instance, however, contact layer 12 and confining layer 16 over the superlattice layer have been removed to show an integrated laser/waveguide structure. Laser active regions 60 and 62 are constructed identically to that shown in Figs. 2—3, except that each terminates in a pair of superlattice waveguides 64 and 66. A metal contact 68 (similar to that shown in Fig. 5) overlays waveguide 66 and is reverse (or even forward) biased to provide a Schottky barrier junction between itself and underlying superlattice 66. The individual devices have been isolated by selective disordering as described above.

Laser 60 is biased in such a mode as to generate light; however, laser 62 is biased sufficiently below threshold that it can be optically pumped by in-phase radiation travelling along superlattice waveguides 64 and 66. Due to fact that the lower gap material (red) exhibits a higher index of refraction than the yellow material, the emitted red light tends to stay within the lower gap material making up waveguides 64 and 66 (so long as there are no abrupt changes of direction of the waveguide materials). By properly energizing contact 68, a retarding electro-optic effect can be achieved which will alter the phase of the signal on waveguide 66 so as to create an out-of-phase signal at the juncture feeding laser 62. Under these conditions, laser 62 is inhibited from lasing. If contact 68 is not energized, in phase optical pumping enables laser 62 to lase, thereby providing an electro-optic logic device.

In summary it has been found that superlattice layers can be disordered and shifted up in energy gap, while remaining single crystal, by introduction of a disordering element, such as by diffusion or implantation. This enables the production of integrated electro-optical and semiconductor devices through a disordering/isolation process.

While the invention has been shown in regard to a number of specific embodiments, it should be understood that a number of alterations within the scope of the invention may be contemplated, among which are: the doping in every instance can be inverted (from p to n and n to p); and/or all superlattice regions can be either doped or undoped and/or the substrate can be semi-insulating, etc.

**Claims**

1. A method of forming a disordered semiconductor alloy, the method comprising introducing a disordering element into a semiconductor structure including a first active semiconductor region (22) disposed on a second semiconductor barrier layer (24) and which together have a crystalline structure whereby the disordering element compositionally disorders the first active region and the second barrier layer while the crystalline structure is maintained, and the alloy formed of the first and second semiconductors exhibits a higher energy gap than the first active semiconductor region.

2. A method according to claim 1, wherein the semiconductor structure comprises a multilayer semiconductor structure (20) having a plurality of first active semiconductor regions (22) interposed between second semiconductor barrier layers (24), the disordering element compositionally disordering the multilayer structure whereby the multilayer structure is converted into a disordered alloy of both the first and second semiconductors.

3. A method according to claim 2, wherein the semiconductor structure comprises a heterojunction multilayer structure forming at least some of a semiconductor device, the method further comprising prior to the introduction step, masking portions of the semiconductor device; and the introduction step comprising introducing the disordering element into unmasked portions of the device to cause the first active regions (22) and the second barrier layers (24) to compositionally disorder to a higher energy gap material than the first active semiconductor regions, whereby the semiconductor device is integrated into a monolithic structure.

4. A method according to claim 3, further comprising prior to the masking step, constructing the semiconductor device including the heterojunction multilayer structure.

5. A method according to claim 1, further comprising prior to the introduction step, forming the semiconductor structure by disposing a first active semiconductor region (22) on a second semiconductor barrier layer (24).

6. A method according to any of the preceding claims, wherein the thickness of the or each first active semiconductor region (22) is less than substantially 50 nm.

7. A method according to claim 6, wherein the thickness of the or each first active semiconductor region (22) is less than substantially 20 nm.

8. A method according to any of the preceding claims, further comprising annealing the semiconductor structure (20), after introduction of the disordering element, at a temperature in the range between substantially 500°C and 700°C.

9. A method according to any of the preceding claims, further including the additional step of bombarding the semiconductor structure (20), after the introduction of a disordering element, with protons.

10. A method according to any of the preceding claims, wherein the introduction of a disordering element comprises implantation of ions into the semiconductor structure (20).

11. A method according to any of the preceding claims, wherein the disordering element comprises silicon, zinc or krypton.

12. A method according to any of claims 1 to 9, wherein the introduction of a disordering element comprises diffusing zinc atoms into the semiconductor structure.

13. A method according to any of the preceding claims, wherein the first and second semiconductors are III—V semiconductors.

14. A method according to any of the preceding claims, wherein the or each first active semiconducting region (22) is GaAs.

15. A method according to any of preceding claims, wherein the or each second semiconductor barrier layer (24) is AlAs.

16. A method according to any of claims 1 to 14, wherein the or each second semiconductor barrier layer (24) is $Al_xGa_{1-x}As$.

**Patentansprüche**

1. Verfahren zum Herstellen einer fehlgeordneten Halbleiterlegierung, bei welchem ein eine Fehlordnung verursachendes Element in eine Halbleiterstruktur eingeführt wird, die eine erste aktive Halbleiterzone (22), welche auf einer zweiten Halbleiter-Barrierschicht (24) angeordnet ist, welche zusammen eine kristalline Struktur aufweisen, wobei das die Fehlordnung verursachende Element eine zusammensetzungsmäßige Fehlordnung der ersten aktiven Zone und der zweiten Barrierschicht bewirken, während die Kristallstruktur erhalten bleibt und die Legierung aus dem ersten und dem zweiten Halbleiter eine größere Energiebandlücke aufweist als die erste aktive Halbleiterzone.

2. Verfahren nach Anspruch 1, bei dem die Halbleiterstruktur eine Mehrschicht-Halbleiterstruktur (20) enthält, welche eine Mehrzahl von ersten aktiven Halbleiterzonen (22) aufweist, die zwischen zweiten Halbleiter-Barrierschichten (24) angeordnet sind, wobei das die Fehlordnung bewirkende Element eine zusammensetzungsmäßige Fehlordnung der Mehrschichtstruktur bewirkt, wodurch die Mehrschichtstruktur in eine eine Fehlordnung aufweisende Legierung des ersten und des zweiten Halbleiters umgewandelt wird.

3. Verfahren nach Anspruch 2, bei welchem die Halbleiterstruktur eine Heteroübergang-Mehrschichtstruktur enthält, welche mindestens einen Teil einer Halbleitereinrichtung bildet, dadurch gekennzeichnet, daß das Verfahren vor dem Einführungsschritt weiterhin eine Maskierung von Teilen der Halbleitereinrichtung umfaßt; und wobei der Einführungsschritt die Einführung des die Fehlordnung verursachenden Elements in unmaskierte Teile der Einrichtung umfaßt, um eine zusammensetzungsmäßige Fehlordnung der ersten aktiven Zonen und der zweiten Barrierschichten (24) in ein Material höherer Energiebandlücke als die ersten aktiven Halbleiterzonen zu bewirken, wobei die Halbleitereinrichtung in eine monolithische Struktur integriert wird.

4. Verfahren nach Anspruch 3, das vor dem Maskierungsschritt außerdem eine Konstruktion der Halbleitereinrichtung einschließlich der Heteroübergang-Mehrschichtstruktur enthält.

5. Verfahren nach Anspruch 1, das vor dem Einführungsschritt außerdem eine Bildung der Halbleiterstruktur durch Aufbringen einer ersten aktiven Halbleiterzone (22) auf eine zweite Halbleiter-Barrierschicht (24) enthält.

6. Verfahren nach einem der vorhergehenden Ansprüche, bei welchem die Dicke der oder jeden aktiven Halbleiterzone (22) kleiner als im wesentlichen 50 nm ist.

7. Verfahren nach Anspruch 6, bei welchem die Dicke der oder jeder aktiven Halbleiterzone (22) kleiner als im wesentlichen 20 nm ist.

8. Verfahren nach einem der vorhergehenden Ansprüche, welches weiterhin ein Erhitzen der Halbleiterstruktur (20) auf eine Temperatur im Bereich zwischen im wesentlichen 500°C und 700°C nach der Einführung des die Fehlordnung verursachten Elements umfaßt.

9. Verfahren nach einem der vorhergehenden Ansprüche, welches den weiteren Schritt enthält, die Halbleiterstruktur (20) nach der Einführung eines eine Fehlordnung verursachenden Elements mit Protonen zu beschießen.

10. Verfahren nach einem der vorhergehenden Ansprüche, dadurch gekennzeichnet, daß die Einführung des eine Fehlordnung verursachenden Elements eine Implantation von Ionen in die Halbleiterstruktur (20) umfaßt.

11. Verfahren nach einem der vorhergehenden Ansprüche, bei welchem das die Fehlordnung verursachende Element Silicium, Zink oder Krypton enthält.

12. Verfahren nach einem der Ansprüche 1 bis 9, dadurch gekennzeichnet, daß die Einführung des eine Fehlordnung verursachenden Elements die Eindiffusion von Zinkatomen in die Halbleiterstruktur umfaßt.

13. Verfahren nach einem der vorhergehenden Ansprüche, bei welchem der erste und der zweite Halbleiter $A_{III}$—$B_V$—Halbleiter sind.

14. Verfahren nach einem der vorhergehenden Ansprüche, bei welchem die oder jede erste aktive Halbleiterzone (22) GaAs ist.

15. Verfahren nach einem der vorhergehenden Ansprüche, bei welchem die oder jede zweite Halbleiter-Barrierschicht (24) AlAs ist.

16. Verfahren nach einem der Ansprüche 1 bis 14, bei welchem der oder jede zweite Halbleiter-Barrierschicht (24) $Al_xGa_{1-x}As$ ist.

**Revendications**

1. Un procédé de formation d'un alliage semiconducteur désordonné, le procédé comprenant l'introduction d'un élément de génération de désordre dans une structure semiconductrice comportant une première région de semiconducteur active (22) disposée sur une seconde couche de barrière en semiconducteur (24), qui ont conjointement une structure cristalline, grâce à quoi l'élément de génération de désordre introduit un désordre dans la composition de la première couche active et de la seconde couche de barrière, tout en conservant la structure cristalline, et l'alliage formé par les premier et second semiconducteurs présente une bande d'énergie interdite plus élevée que la première région de semiconducteur active.

2. Un procédé selon la revendication 1, dans lequel la structure semiconductrice comprend une structure semiconductrice multicouche (20) ayant une ensemble de premières régions de semiconducteur actives (22) intercalées entre des secondes couches de barrière en semiconducteur (24), l'élément de génération de désordre introduisant un désordre dans la composition de la structure multicouche, grâce à quoi cette dernière est convertie en un alliage désordonné des premier et second semiconducteurs.

3. Un procédé selon la revendication 2, dans lequel la structure semiconductrice comprend une structure multicouche à hétérojonctions formant une partie au moins d'un dispositif à semiconducteurs, le procédé comprenant en outre, avant l'opération d'introduction, le masquage de parties du dispositif à

**0 077 825**

semiconducteurs; et l'opération d'introduction comprenant l'introduction de l'élément de génération de désordre dans des parties non masquées du dispositif, pour faire en sorte que les premières régions actives (22) et les secondes couches de barrière (24) présentent un désordre de composition donnant naissance à une matière à bande d'énergie interdite plus élevée que celle des premières régions de semiconducteurs actives, grâce à quoi le dispositif à semiconducteurs est intégré dans une structure monolithique.

4. Un procédé selon la revendication 3, comprenant en outre, avant l'opération de masquage, la formation du dispositif à semiconducteurs comprenant la structure multicouche à hétérojonctions.

5. Un procédé selon la revendication 1, comprenant en outre, avant l'opération d'introduction, la formation de la structure semiconductrice en établissant une première région de semiconducteur active (22) sur une seconde couche de barrière en semiconducteur (24).

6. Un procédé selon l'une quelconque des revendications précédentes, dans lequel l'épaisseur de la première région de semiconducteur active, ou de chacune de ces premières régions (22), est inférieure à environ 50 nm.

7. Un procédé selon la revendication 6, dans lequel l'épaisseur de la première région de semiconducteur active (22), ou de chacune de ces premières régions, est inférieure à environ 20 nm.

8. Un procédé selon l'une quelconque des revendications précédentes, comprenant en outre l'opération qui consiste à recuire la structure semiconductrice (20), après l'introduction de l'élément de génération de désordre, à une température dans la plage comprise approximativement entre 500°C et 700°C.

9. Un procédé selon l'une quelconque des revendications précédentes, comprenant en outre l'opération supplémentaire qui consiste à bombarder la structure semiconductrice (20) avec des protons, après l'introduction d'un élément de génération de désordre.

10. Un procédé selon l'une quelconque des revendications précédentes, dans lequel l'introduction d'un élément de génération de désordre comprend l'implantation d'ions dans la structure semiconductrice (20).

11. Un procédé selon l'une quelconque des revendications précédentes, dans lequel l'élément de génération de désordre consiste en silicium, en zinc ou en krypton.

12. Un procédé selon l'une quelconque des revendications 1 à 9, dans lequel l'introduction d'un élément de génération de désordre comprend la diffusion d'atomes de zinc dans la structure semiconductrice.

13. Un procédé selon l'une quelconque des revendications précédentes, dans lequel les premier et second semiconducteurs sont des semiconducteurs du type III—V.

14. Un procédé selon l'une quelconque des revendications précédentes, dans lequel la première région de semiconducteur active (22), ou chacune de ces premières régions, consiste en GaAs.

15. Un procédé selon l'une quelconque des revendications précédentes, dans lequel la seconde couche de barrière en semiconducteur (24), ou chacune de ces couches de barrière, consiste en AlAs.

16. Un procédé selon l'une quelconque des revendications 1 à 14, dans lequel la seconde couche de barrière en semiconducteur (24), ou chacune de ces secondes couches de barrière, consiste en $Al_xGa_{1-x}As$.

Fig. 1

Fig. 2

Fig. 3

Fig. 4

Fig. 5

Fig. 6